(19) Europäisches Patentamt
European Patent Office
Office européen des brevets

(11) Numéro de publication : **0 308 293 B1**

(12) **FASCICULE DE BREVET EUROPEEN**

(45) Date de publication du fascicule du brevet :
07.08.91 Bulletin 91/32

(51) Int. Cl.⁵ : **H03G 1/00, H03G 3/20, G01S 7/28**

(21) Numéro de dépôt : 88402214.6

(22) Date de dépôt : 02.09.88

(54) Dispositif de commande de la puissance de sortie d'un amplificateur fonctionnant en classe C.

(30) Priorité : 08.09.87 FR 8712443

(43) Date de publication de la demande :
22.03.89 Bulletin 89/12

(45) Mention de la délivrance du brevet :
07.08.91 Bulletin 91/32

(84) Etats contractants désignés :
DE GB IT NL

(56) Documents cités :
EP-A- 0 025 681
ELECTRICAL COMMUNICATION, vol. 50, no. 4,
1975, pages 278-286; J.D. JACKSON: "High
pulsed power L-band transistorized sources"
W. GOSLING et al.: "FIELD-EFFECT ELEC-
TRONICS", 1971, pages 215-249, Butterworth
& Co., Ltd., Londres, GB

(56) Documents cités :
PATENT ABSTRACTS OF JAPAN, vol. 10, no.
104 (E-397)[2161], 19 avril 1986; & JP-A-60 244
107 (NIPPON DENKI K.K.) 04-12-1985
PATENT ABSTRACTS OF JAPAN, vol. 7, no.
204 (E-197)[1349], 9 septembre 1983; & JP-A-58
101 512 (HITACHI DENSHI K.K.) 16-06-1983

(73) Titulaire : THOMSON-CSF
51, Esplanade du Général de Gaulle
F-92800 Puteaux (FR)

(72) Inventeur : Benahim, Guy
THOMSON-CSF SCPI 19, avenue de Messine
F-75008 Paris (FR)
Inventeur : Dutaut, Jean-Michel
THOMSON-CSF SCPI 19, avenue de Messine
F-75008 Paris (FR)
Inventeur : Giraudon, Jean-Claude
THOMSON-CSF SCPI 19, avenue de Messine
F-75008 Paris (FR)

(74) Mandataire : Benoit, Monique et al
THOMSON-CSF SCPI
F-92045 PARIS LA DEFENSE CEDEX 67 (FR)

Jouve, 18, rue Saint-Denis, 75001 PARIS

## Description

L'invention concerne un dispositif de commande de la puissance de sortie d'un amplificateur fonctionnant en classe C, et plus particulièrement, d'un amplificateur du type à transistor bipolaire.

Les amplificateurs de puissance fonctionnant en classe C sont utilisés notamment pour amplifier des impulsions du type de celles utilisées par les radars, c'est-à-dire des impulsions avec fréquence porteuse. Les contraintes essentielles de ces amplificateurs de puissance sont, pour une onde de fréquence donnée:

— une puissance de sortie constante ;
— une puissance d'entrée constante ;
— une tension d'alimentation constante ;
— un temps de montée de l'impulsion déterminé;
— une chute de puissance déterminée au cours de l'impulsion.

Ces cinq contraintes ne peuvent être tenues simultanément dans le cas d'amplificateurs de puissance utilisant des transistors bipolaires fonctionnant en classe C. En effet, dans ce cas, il existe une ondulation de la puissance de sortie qui est due à une désadaptation à la sortie. Il en résulte que lorsque de tels amplificateurs sont mis en série, le dernier a des niveaux de puissances d'entrée trop dispersés dans la bande de fréquence pour pouvoir fonctionner dans de bonnes conditions.

Pour remédier à ce problème, on a réalisé des amplificateurs avec une tension d'alimentation variable ou une puissance d'entrée variable. Pour obtenir une tension d'alimentation variable, on agit sur la tension d'alimentation Vcc du collecteur du transistor bipolaire pour contrôler le niveau de la puissance de sortie ; la tension est obtenue grâce à une batterie de condensateurs et, de ce fait, la variation n'est pas immédiate à réaliser entre deux impulsions, surtout si celles-ci sont espacées d'un temps très court de l'ordre de quelques microsecondes. En outre, une variation de la tension d'alimentation Vcc s'accompagne d'une variation de la phase de quelques degrés par volt, ce qui ne peut être toléré dans certaines applications, notamment dans les radars du type à compression d'impulsion.

Pour obtenir une puissance d'entrée variable, on insère un atténuateur commandé par l'information de puissance de sortie dans la chaîne d'amplification. Un tel procédé présente les inconvénients suivants :

— la perte d'insertion est importante, de l'ordre de quelques décibels ;
— le coût de l'atténuateur est élevé lorsqu'il faut dissiper de fortes puissances crêtes et moyennes ;
— l'impulsion de sortie est déformée, notamment à son début, car il existe un phénomène de retard entre l'information de puissance et l'effet de l'atténuateur.

Un but de la présente invention est donc de réaliser un dispositif de régulation de la puissance de sortie d'un transistor bipolaire fonctionnant en classe C qui ne présente pas les inconvénients précités des dispositifs de l'art antérieur.

Un autre but de la présente invention est de réaliser un dispositif de régulation de la puissance de sortie d'un transistor bipolaire classe C qui fonctionne dans une large bande de fréquence.

Dans certains radars, il est prévu de modifier, dans certaines circonstances, la puissance de sortie des impulsions émises, alors que la puissance d'entrée reste constante à l'entrée de l'amplificateur de puissance classe C, cette puissance de sortie étant prédéterminée.

En conséquence, un autre but de la présente invention est, d'une manière générale, de réaliser un dispositif de commande de la puissance de sortie d'un amplificateur à transistor bipolaire fonctionnant en classe C de manière à obtenir une puissance de sortie prédéterminée quelles que soient les valeurs de la puissance et de la fréquence du signal d'entrée choisie parmi un certain nombre de valeurs prédéterminées.

Il est connu que la puissance de sortie d'un amplificateur dépend de la température atteinte par les éléments le composant, notamment celle du transistor ; aussi un autre but de la présente invention est de réaliser un tel dispositif de commande de la puissance de sortie d'un amplificateur à tension bipolaire fonctionnant en classe C dont la puissance de sortie est indépendante de la température du boîtier contenant le transistor bipolaire.

L'invention se rapporte à un dispositif de commande de la puissance de sortie d'un amplificateur fonctionnant en classe C et comportant au moins un transistor bipolaire en base commune auquel on applique un signal d'entrée entre la base et l'émetteur, caractérisé en ce que le circuit de polarisation émetteur-base comprend un élément dont la résistance varie en fonction de la tension qui lui est appliquée et en ce que ladite tension est choisie dans un ensemble de valeurs définies expérimentalement en fonction de la puissance de sortie à obtenir et/ou de la puissance d'entrée du signal à amplifier et/ou de la fréquence du signal à amplifier et/ou de la température du transistor bipolaire.

Dans une réalisation particulière, l'élément à résistance variable est un transistor à effet champ auquel on applique la tension variable entre la grille et la source.

De préférence, les valeurs de la tension variable sont enregistrées sous forme numérique dans une mémoire qui est adressée par un ou plusieurs codes représentatifs de la puissance de sortie à obtenir, et/ou de la puissance du signal à amplifier et/ou de la fréquence du signal à amplifier.

D'autres caractéristiques et avantages de la présente invention apparaîtront à la lecture de la description suivante d'un exemple particulier de réalisation, ladite description étant faite en relation avec les dessins joints dans lesquels :

— la figure 1 est le schéma d'un amplificateur du type transistor bipolaire fonctionnant en classe C qui présente des caractéristiques de la présente invention ;

— la figure 2 est un diagramme de courbes de variation de la puissance de sortie Ps d'un amplificateur du type transistor bipolaire classe C en fonction de la tension Vgs appliquée au transistor 14 du circuit de la figure 1 ;

— la figure 3 est un tableau indiquant les tensions Vgs qu'il faut appliquer au transistor 14 du circuit de la figure 1 pour obtenir une puissance de sortie Ps prédéterminée en fonction de la puissance d'entrée Pe et de la fréquence Fi de l'impulsion à amplifier ;

— la figure 4 est un schéma fonctionnel d'un exemple particulier de réalisation d'un circuit d'élaboration de la tension Vgs à appliquer au transistor 14 du circuit de la figure 1, et

— la figure 5 est un schéma fonctionnel d'un autre exemple particulier de réalisation de la tension Vgs à appliquer au transistor 14 du circuit de la figure 1.

Un amplificateur de puissance 1 de l'art antérieur fonctionnant en classe C comprend un transistor bipolaire 2 dont la base est connectée à la masse et l'émetteur connecté à une borne d'entrée 10 par un condensateur de liaison 16. Une bobine 3 est connectée entre l'émetteur et une borne de masse 12. Le collecteur du transistor 2 est connecté à une borne de sortie 11 par un condensateur de liaison 7. L'impédance de sortie est connectée entre le collecteur et la masse et comprend en série une bobine 5 et un condensateur 6. Une tension d'alimentation symbolisée par une batterie 9 est appliquée au collecteur et charge un condensateur réservoir 8. Un signal d'entrée de puissance Pe, par exemple une impulsion haute fréquence d'un radar, est appliqué entre la borne 10 et la borne de masse 12 et l'amplificateur 1 fournit un signal de sortie de puissance Ps entre la borne 11 et une borne de masse 13.

Il est à noter, qu'en pratique, le transistor 2 n'est pas unique car il ne pourrait pas supporter la puissance du signal d'entrée. Aussi, ce transistor 2 représente une pluralité de transistors, plusieurs centaines dans certains amplificateurs, montés en parallèle. Dans la suite de la description, ce transistor 2 sera considéré comme unique et présentant des caractéristiques déterminées fournies par le fabricant.

Comme on l'a indiqué dans le préambule, il n'est pas possible d'obtenir avec un tel circuit une puissance de sortie constante, quelles que soient la puissance d'entrée, la fréquence et la température.

Selon la présente invention, il est proposé de modifier le circuit d'entrée en connectant un transistor à effet de champ 14 entre la bobine 3 et la borne de masse 12 de telle manière que le drain D soit connecté à la bobine 3, la source S à la masse et la grille G à une borne 15. En outre, un condensateur 4 est connecté en parallèle sur le transistor 14 entre le drain et la source. Il est prévu d'appliquer une tension variable Vgs entre les bornes 15 et 12 de manière à faire varier la résistance drain-source Rds du transistor 14 et, par voie de conséquence, le courant de polarisation Ieo et la tension de polarisation, c'est-à-dire modifier le gain en puissance du transistor 2.

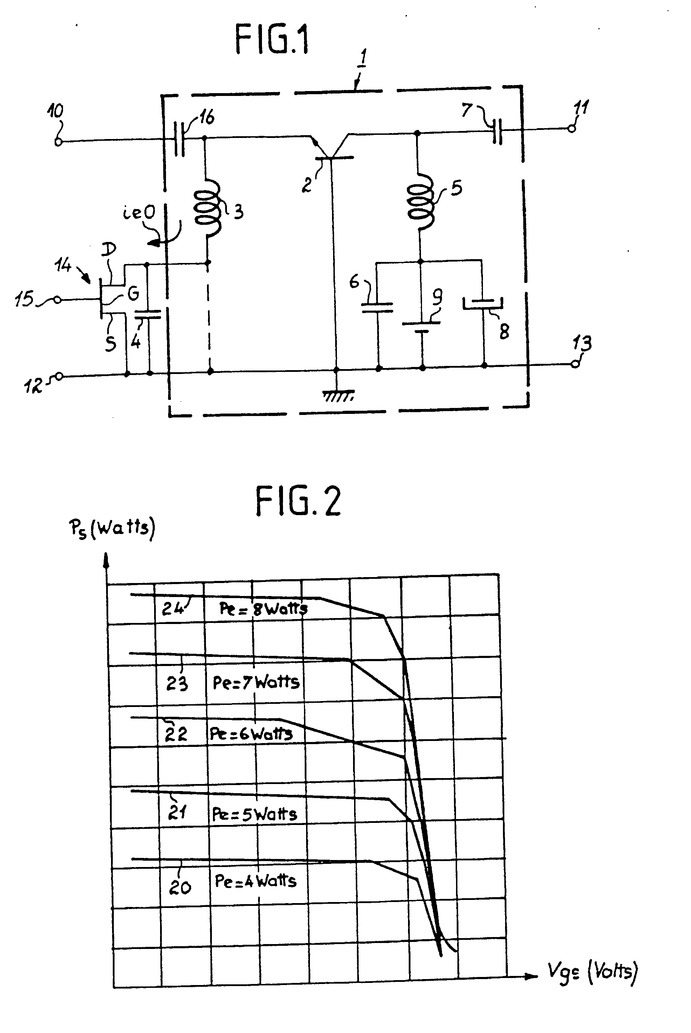

Pour connaître les valeurs de la tension Vgs à appliquer, il faut déterminer la fonction qui relie la puissance de sortie à la tension Vgs. Pour cela, on relève les courbes de variation de la puissance de sortie Ps en fonction de la tension Vgs pour différentes puissances d'entrée Pe et à une fréquence déterminée ; on obtient le diagramme des courbes 20 à 24 de la figure 2 pour une certaine fréquence F1. Cette opération est répétée pour d'autres fréquences F2.... Fi.... Fn de manière à couvrir la gamme d'utilisation de l'amplificateur ou encore celle des fréquences porteuses des impulsions d'un radar à diversité de fréquences.

Ces diagrammes peuvent être utilisés de la manière suivante : par exemple, si l'on souhaite une puissance de sortie Ps de 16 W à la fréquence F1, la tension Vgs sera de 4 volts pour Pe = 8 W et de 5 volts pour Pe = 7 W.

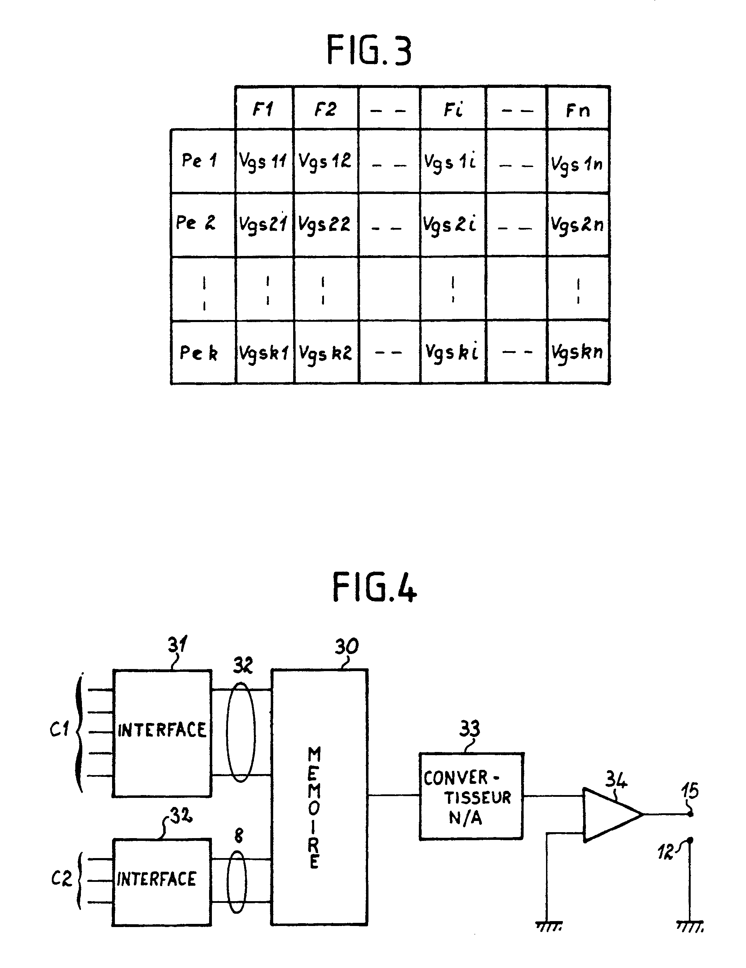

Ces n différents diagrammes, correspondant chacun à une fréquence Fi, permettent de réaliser un tableau à double entrée (figure 3) dans lequel la tension Vgs est déterminée en fonction de la puissance d'entrée et de la fréquence Fi de manière à obtenir une puissance de sortie déterminée Ps. D'autres tableaux pourraient être établis pour d'autres valeurs de la puissance de sortie afin d'obtenir un étalonnage complet ; cependant ceci n'est, en général, pas nécessaire car l'une des caractéristiques déterminantes d'un amplificateur est de présenter une puissance de sortie Ps constante quelle que soit la puissance d'entrée Pe et la fréquence Fi du signal d'entrée. En conséquence, cet étalonnage est effectué pour la valeur souhaitée de la puissance de sortie Ps, par exemple Ps = 16 W.

Selon l'invention, les différentes valeurs de la tension Vgs, qui sont répertoriées sur le tableau de la figure 3, sont enregistrées sous forme numérique dans une mémoire. Cette mémoire est adressée par un premier code C1 qui définit l'une des fréquences F1 à Fn et par un deuxième code C2 qui définit les puissances d'entrée Pe1 à Pek.

Le schéma fonctionnel simplifié d'un dispositif électronique d'élaboration des tensions Vgs est donné par la figure 4. Il comprend une mémoire 30 du type programmable et effaçable, deux circuits d'interface 31 et 32 qui reçoivent l'un 31, le code C1 de la fréquence et l'autre 32, le code C2 de la puissance d'entrée, un convertisseur numérique-analogique 33 et un amplificateur 34. Pour n = 32, le code C1 aura cinq chiffres et pour k = 8 le code C2 aura trois chiffres.

Le fonctionnement du dispositif de la figure 4 est le suivant, en supposant que les impulsions à amplifier sont celles d'un radar à diversité de fréquences. Le générateur des séquences des impulsions radar fournit le code C1 de la fréquence porteuse Fi choisie pour l'impulsion radar ainsi que le code C2 de la puissance d'entrée Pe de l'impulsion qui sera appliquée à l'amplificateur de puissance. Ces deux codes C1 et C2 permettent de choisir dans le mémoire 30, la valeur numérique de la tension Vgs, tension qui doit être appliquée entre les bornes 15 et 12 du transistor à effet de champ 14. Cette valeur numérique est transformée en une valeur analogique par un convertisseur numérique-analogique 33, ladite valeur analogique étant ensuite amplifiée par un amplificateur 34, avant d'être appliquée aux bornes 15 et 12 du transistor 14.

A l'aide d'un dispositif combinant les circuits décrits en relation avec les figures 1 et 4, on obtient aux bornes 11 et 13 une puissance de sortie prédéterminée et constante pour un certain nombre de couples de valeurs de la puissance d'entrée et de la fréquence du signal appliqué aux bornes 10 et 12.

L'invention a été décrite dans le cas le plus fréquent où l'on veut obtenir une puissance de sortie constante alors que la puissance d'entrée et la fréquence sont variables mais connues a priori. Il est clair, cependant, qu'elle est applicable également au cas où l'on souhaiterait obtenir une puissance de sortie ayant différentes valeurs. Il suffirait alors d'établir, à l'aide des diagrammes de courbes de la figure 2, un tableau à trois entrées, la troisième entrée étant celle de la puissance de sortie Ps. Ceci conduirait à une mémoire 30 plus importante qui serait adressée par les deux codes C1 et C2 définis ci-dessus mais aussi par un troisième code C3 définissant la puissance de sortie choisie.

Egalement, l'invention a été décrite en mettant en oeuvre un transistor à effet de champ 14 disposé dans le circuit de polarisation du transistor bipolaire mais on comprendra que ce transistor à effet de champ 14 peut être remplacé par tout élément dont la résistance varie en fonction de la tension qui lui est appliquée.

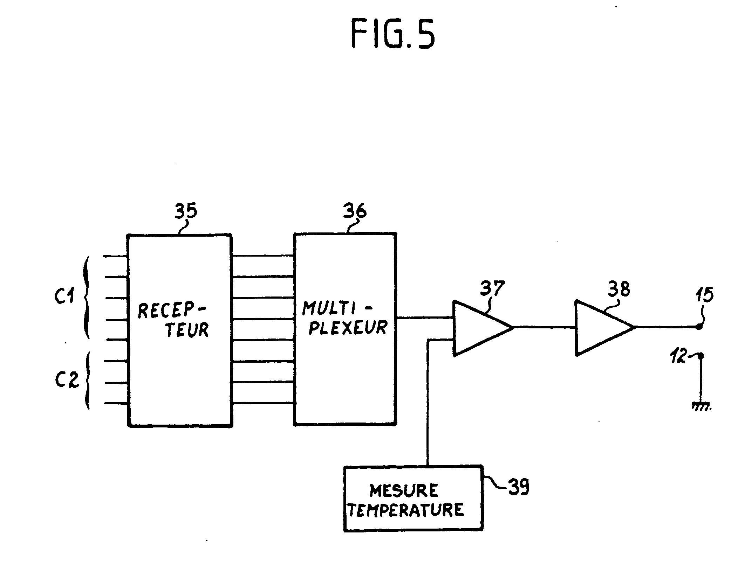

L'exemple particulier de réalisation décrit à l'aide de la figure 4 utilise une mémoire 30 qui est un élément relativement complexe et coûteux et qui doit être utilisé avec des circuits d'interface 31 et 32. Aussi, il est proposé un exemple de réalisation plus simple qui sera maintenant décrit à l'aide de la figure 5. En outre, ce deuxième exemple de réalisation est prévu pour tenir compte de la température d'environnement du transistor 2, c'est-à-dire celle du boîtier.

Ce dispositif comprend un récepteur 35 des codes C1 de la fréquence et C2 de la puissance d'entrée, un multiplexeur 36, un premier amplificateur différentiel 37, un amplificateur de courant 38 et un appareil de mesure 39 de la température Te du boîtier contenant le transistor bipolaire 2 (figure 1). Cet appareil 39 fournit par exemple une tension analogique Vt qui est représentative de la température du boîtier Tb et qui est appliquée à l'une des deux bornes d'entrée de l'amplificateur 37, l'autre borne d'entrée recevant le signal de sortie du multiplexeur 36. Ce multiplexeur 36 fournit une tension analogique qui est égale à Vgs et qui est modifiée par l'amplificateur différentiel 37 de manière à tenir compte de la tension Vt représentative de la température du boîtier Tb.

Sur la figure 5, la correction due à la température du boîtier a été réalisée sous forme analogique mais on comprend que cette correction peut également être effectuée sous forme numérique à l'aide d'un quatrième code C4 représentatif de la température, la combinaison des codes C1 à C4 déterminant une valeur Vg1 selon les régles et critères décrits ci-dessus en relation avec les figures 1 à 4.

La présente invention peut également être mise en oeuvre dans un dispositif dans lequel il ne serait nécessaire que d'avoir une seule variable d'entrée, soit la fréquence Fi, soit la puissance d'entrée Pe, soit la puissance de sortie Ps, soit encore la température du boîtier Tb.

## Revendications

1. Dispositif de commande de la puissance de sortie d'un amplificateur fonctionnant en classe C et comportant au moins un transistor bipolaire en base commune (2) auquel on applique un signal à amplifier entre la base et l'émetteur, caractérisé en ce que le circuit de polarisation émetteur-base comprend un élément (14) dont la résistance varie en fonction de la tension (Vgs) qui lui est appliquée et en ce que ladite tension (Vgs) appliquée au dit élément (14) à résistance variable est choisie dans un ensemble de valeurs définies expérimentalement en fonction de la puissance de sortie à obtenir et/ou de la puissance d'entrée et/ou de la fréquence du signal à amplifier et/ou de la température du transistor bipolaire.

2. Dispositif de commande selon la revendication 1, caractérisé en ce que l'élément à résistance variable est un transistor à effet de champ (14) dont le drain (D) est connecté à l'émetteur du transistor (2), et dont la source (S) est connnectée à la base du transistor (2), la tension Vgs étant appliquée à la grille (G).

3. Dispositif de commande selon la revendication 1 ou la revendication 2, caractérisé en ce que l'ensemble des valeurs de Vgs est enregistré sous forme numérique dans une mémoire (30) qui est adressée par un ou plusieurs codes représentatifs de la puissance de sortie à obtenir, de la puissance d'entrée, de la fréquence du signal d'entrée ou de la température du transistor bipolaire.

4. Dispositif de commande selon la revendication 3, caractérisé en ce que la valeur numérique lue dans la mémoire (30) est transformée en une valeur analogique par un convertisseur numérique/analogique (34).

5. Dispositif de commande selon l'une des revendications 1 ou 2, caractérisé en ce que chacune des valeurs de Vgs est obtenue par un multiplexeur (36) qui reçoit un ou plusieurs codes représentatifs de la puissance de sortie à obtenir, de la puissance d'entrée, de la fréquence du signal d'entrée ou de la température du transistor bipolaire.

6. Dispositif de commande selon l'une des revendications 1 ou 2, caractérisé en ce que chacune des valeurs de Vgs est obtenue par un multiplexeur (36) qui reçoit un ou plusieurs codes représentatifs de la puissance de sortie à obtenir, de la puissance d'entrée ou de la fréquence du signal d'entrée et par un amplificateur différentiel (37) qui reçoit, d'une part, un signal de sortie analogique dudit multiplexeur (36) et, d'autre part, un signal analogique représentatif de la température du transistor bipolaire.

**Patentansprüche**

1. Vorrichtung zur Leistungssteuerung eines Klasse-C-Verstärkers, der mindestens einen bipolaren Transistor (2) in Basisschaltung aufweist, wobei ein zu verstärkendes Signal zwischen Basis und Emitter dieses Transistors angelegt wird, dadurch gekennzeichnet, daß der Schaltkreis zur Emitter-Basis-Vorspannung ein Element (14) enthält, dessen Widerstand von der an dieses Element angelegten Spannung (Vgs) abhängt, und daß diese Spannung (Vgs), die an das Element (14) mit variablem Widerstand angelegt wird, aus einer Gruppe von experimentell definierten Werten abhängig von der zu erzielenden Ausgangsleistung und/oder der Eingangsleistung und/oder der Frequenz des zu verstärkenden Signals und/oder der Temperatur des bipolaren Transistors ausgewählt wird.

2. Steuervorrichtung nach Anspruch 1, dadurch gekennzeichnet, daß das Element mit variablem Widerstand ein Feldeffekttransistor (14) ist, dessen Drain (D) an den Emitter des Transistors (2) und dessen Quelle (S) an die Basis dieses Transistors (2) angeschlossen ist, während die Spannung (Vgs) an das Gate (G) angelegt wird.

3. Steuervorrichtung nach Anspruch 1 oder 2, dadurch gekennzeichnet, daß die Gruppe der Werte der Spannung (Vgs) in digitaler Form in einem Speicher (30) registriert ist, der von einem oder mehreren für die zu erzielende Ausgangsleistung, die Eingangsleistung, die Frequenz des Eingangssignals oder die Temperatur des bipolaren Transistors repräsentativen Kodes adressiert wird.

4. Steuervorrichtung nach Anspruch 3, dadurch gekennzeichnet, daß der digitale Wert, der aus dem Speicher (30) ausgelesen wird, in einen analogen Wert durch einen Digital-Analog-Wandler (30) umgewandelt wird.

5. Steuervorrichtung nach einem der Ansprüche 1 und 2, dadurch gekennzeichnet, daß jeder der Werte der Spannung (Vgs) durch einen Multiplexer (36) erhalten wird, der einen oder mehrere für die zu erzielende Ausgangsleistung, die Eingangsleistung, die Frequenz des Eingangssignals oder die Temperatur des bipolaren Transistors repräsentative Kodes empfängt.

6. Steuervorrichtung nach einem der Ansprüche 1 und 2, dadurch gekennzeichnet, daß jeder der Werte der Spannung (Vgs) einerseits durch einen Multiplexer (36), der einen oder mehrere für die zu erzeilende Ausgangsleistung, die Eingangsleistung oder die Frequenz des Eingangssignals repräsentative Kodes empfängt, und durch einen Differentialverstärker (37) erzielt wird, der einerseits ein analoges Ausgangssignal des Multiplexers (36) und andererseits ein für die Temperatur des bipolaren Transistors repräsentatives analoges Signal zugeführt erhält.

**Claims**

1. A device for controlling the output power of an amplifier operated under glass C conditions and comprising at least one bipolar transistor (2) whose base electrode is the common electrode and to which a signal to be amplified is applied between the base and emitter electrodes, characterized in that the emitter-base bias circuit comprises an element (14) whose resistance varies in accordance with the voltage (Vgs) applied thereto, and that said voltage (Vgs) applied to that variable resistance element (14) is selected from a set of values which are defined by experiment as a function of the output power to be obtained and/or the input power and/or the frequency of the signal to be amplified and/or the temperature of the bipolar transistor.

2. A control device according to claim 1, characterized that said variable resistance element is a FET (14) drain (D) is connected to the emitter of the transistor (2) and whose source (S) is connected to the base electrode of the transistor (2), the voltage (Vgs) being applied to the gate (G).

3. A control device according to claim 1 or 2, characterized in that said set of values of the voltage (Vgs) is stored in digital form in a memory (30) which is addressed by one or more codes representative of the output power to be obtained, of the input power, of the frequency of the input signal or the temperature of the bipolar transistor.

4. A control device according to claim 3, characterized in that the digital value read out from the memory (30) is transformed into an analog value by a digital/analog converter (34).

5. A control device according to one of claims 1 or 2, characterized in that any one of the voltage values (Vgs) is obtained by a multiplexer (36) receiving one or more codes which are representative of the output power to be obtained, of the input power, of the frequency of the input signal or of the temperature of the bipolar transistor.

6. A control device according to one of claims 1 or 2, characterized in that any one of the voltage values (Vgs) is obtained by a multiplexer (36) receiving one or more codes which are representative of the output power to be obtained, of the input power, or of the frequency of the input signal, and by a differential amplifier (37) receiving on the one hand an analog output signal of said multiplexer (36) and on the other hand an analog signal representative of the temperature of the bipolar transistor.

# FIG.1

# FIG.2

# FIG.3

|  | F1 | F2 | – – | Fi | – – | Fn |
|---|---|---|---|---|---|---|
| Pe 1 | Vgs 11 | Vgs 12 | – – | Vgs 1i | – – | Vgs 1n |
| Pe 2 | Vgs21 | Vgs22 | – – | Vgs 2i | – – | Vgs2n |
| ⋮ | ⋮ | ⋮ | | ⋮ | | ⋮ |
| Pe k | Vgsk1 | Vgs k2 | – – | Vgs ki | – – | Vgskn |

# FIG.4

# FIG.5